# EUROPEAN PATENT APPLICATION

(11) **EP 3 043 453 A1**
(43) Date of publication of application: **13.07.2016**
(21) Application number: 15305006.7
(22) Date of filing: 06.01.2015
(51) Int. Cl.: H02K 7/09, H02N 1/08, H02N 2/18

(54) **Vibration energy harvester**

(71) Applicant: ALCATEL LUCENT, 92100 Boulogne-Billancourt (FR)
(72) Inventor: Kelly, Gerard, Blanchardstown, Dublin (IE); Frizell, Ronan, Blanchardstown, Dublin (IE); Burns, Oliver, Blanchardstown, Dublin (IE)
(74) Representative: Shamsaei Far, Hassan

(57) **Abstract**

An energy harvester having a mass element which is moveable along a line of vibration, housing and a spring for transferring external mechanical disturbances from the housing to the mass element. The mass element and the housing are each provided with respective plurality of permanent magnets configured to cooperate to generate a plurality of magnetic forces. The magnetic forces collectively cancel each other and therefore allow the mass element to move along the line of vibration.

## Description

The present invention relates to techniques for harvesting energy.

### BACKGROUND

Vibration energy harvesting is typically the process of using vibrations from the environment to drive generators that provide power for use in electric/electronic devices. This technology has certain advantages as it is typically capable of providing power autonomy, at least to some extent, to electronic systems that would otherwise have to rely solely on battery power. Battery powered systems typically require routine maintenance to replace the battery, which adds significant cost to the operator of the device. For example, in the case of wireless sensor nodes, the issue of battery replacement may become a major bottleneck to the wide deployment of large wireless sensor networks where it is typically needed that a high number of batteries be replaced routinely. Such battery replacements have cost associated with them which may hamper large-scale deployments of wireless sensor nodes that are useful for constructing the so-called "Smart" systems such as "Smart Buildings" and "Smart Cities".

### SUMMARY

Some embodiments feature an apparatus comprising:
- a first mass element being bidirectionally moveable along a first line of vibration, said first mass element comprising a first plurality of permanent magnets;
- a housing surrounding at least partially the first mass element and comprising a second plurality of permanent magnets;
   wherein the first plurality of permanent magnets and the second plurality of permanent magnets are configured to cooperate to thereby generate a plurality of magnetic forces, such that said magnetic forces collectively balance each other and allow movement of the fist mass element along said first line of vibration.

According to some specific embodiments, a spring is attached to the first mass element and configured to transfer a movement from the housing to the first mass element.

According to some specific embodiments, the first plurality of permanent magnets are provided circumferentially proximate to an outer perimeter of the cross-section of the first mass element.

According to some specific embodiments, the permanent magnets in the first plurality are positioned such that respective outward poles of said permanent magnets are distributed equidistantly around the circumference of the mass element.

According to some specific embodiments, the permanent magnets of the second plurality are provided circumferentially proximate to the inner perimeter of the cross-section of the housing.

According to some specific embodiments, the apparatus comprises a second mass element being bidirectionally moveable along said first line of vibration, said second mass element being at least partially surrounded by the housing and comprising a third plurality of permanent magnets; wherein the third plurality of permanent magnets and the second plurality of permanent magnets are configured to cooperate to thereby generate a plurality of magnetic forces, such that said magnetic forces collectively cancel each other and allow movement of the second mass element along said first line of vibration.

According to some specific embodiments, the apparatus further comprises a coil positioned relative the first set of permanent magnets to act as a transducer to generate electric energy by induction in response to movements of the first mass element and the second mass element.

According to some specific embodiments, the apparatus is configured to move a mass element in unbalanced position to a balanced position.

According to some specific embodiments, the apparatus further comprises a piezoelectric material positioned relative the first and the second mass elements to act as a transducer to generate electric energy in response to an impact of a mass element upon the piezoelectric material.

According to some specific embodiments, the apparatus further comprises a magnetostrictive material positioned relative the first and the second mass elements to act as a transducer to generate electric energy in response to a movement of a mass element relative to the magnetostrictive material. According to some specific embodiments, one or more mass elements and the housing have respective spherical shapes.

According to some specific embodiments, the permanent magnets of the first plurality are provided circumferentially proximate to an outer surface of the spherical mass element and the permanent magnets of the second plurality are provided circumferentially proximate to an inner surface of the spherical housing. According to some specific embodiments, the permanent magnets of the first plurality are positioned such that the respective outward poles of the permanent magnets for the first plurality are distributed equidistantly around the outer surface of the mass element, and the permanent magnets of the second plurality are positioned such that the respective inward poles of the permanent magnets for the second plurality are distributed equidistantly around the inner surface of the housing.

According to some specific embodiments, the spring is made of a non-magnetic material.

According to some specific embodiments, the apparatus comprises a second mass element having a size smaller than the first mass element and being located inside the first mass element.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figure 1 is an exemplary schematic structure illustrating some elements of an energy harvester in which some embodiments of the present disclosure may be implemented.
Figures 2A and 2B are respectively exemplary schematic representations of a top view and a cross-sectional view of an energy harvester according to some embodiments.
Figure 3 is a schematic representation of the top view of the energy harvester of figure 2A in an unbalanced position.
Figure 4 is an exemplary schematic representation of an energy harvester according to some embodiments.

### DETAILED DESCRIPTION OF EXEMPLARY EMBODIMENTS

Before the various embodiments of the disclosure are described in detail, a brief and non-limiting description of some examples of known vibration energy harvesters is provided to help a better understanding of the embodiments of the present disclosure.

As it is known, devices that capture mechanical energy from the environment and convert it to useful form are often referred to as "energy harvesters." Some known energy harvesters are based on linear oscillator designs, which comprise a mass that is attached to the housing of the harvester via a spring. When the device is subjected to a mechanical disturbance (e.g. a vibration caused by a motor or an air conditioning system), forces are transferred from the housing to the spring and this causes the mass to undergo a displacement. Typically such displacement may be in the form of a vibration having certain amplitude and frequency. However, the source of mechanical disturbance may not always be limited to periodic vibrations and can be any source of mechanical disturbance that causes motion of the masses in the energy harvester.

The effect of the spring mass combination is that the mass oscillates out-of-phase with the housing of the energy harvester to a certain extent depending on the source of mechanical disturbance and the attributes of the spring and mass. The oscillation amplitude may damp down or it may increase depending on the effect of the external mechanical disturbance. The out-of-phase behavior is used to extract power if electro-active components are used in the device (e.g. a piezoelectric element, or a magnetically active mass in conjunction with a conducting coil within the housing).

Herein the terms motion and movement are to be understood to have the same meaning which is the act or the result of moving.

However, the effectiveness of such energy harvesters is limited because of the frictional losses between the actuating components. For example the mass may be in physical contact with a guiding axis configured to maintain the movement of the mass along one direction, which is the desired displacement direction (typically parallel to the axis) and avoid displacements of the mass in directions other than the desired directions (e.g. laterally with respect to the axis).

This drawback may be present not only in energy harvesters having one spring-mass combination, i.e. operable with one degree of freedom (DOF), but also in energy harvesters having multiple spring-mass combinations, i.e. multiple-DOF. In the latter case, masses are typically stacked one on top of the other in a linear fashion (i.e. along the line of vibration). This can lead to increased frictional losses as additional masses are added due to increased contact area between the masses and the guiding structure.

Furthermore, is some applications, the masses may be guided by a central pin or by a tube-like enclosure, in either case, additional masses lead to increased frictional losses.

An addition consideration in the case of multiple-DOF is related to the velocity amplification principle. Additional masses in such energy harvester typically lead to velocity amplification. However, these masses are typically smaller than conventional single-DOF systems and therefore the effects of friction on them are more detrimental than they would be to a larger mass in a single DOF system. Therefore, the present solution is even more beneficial when use is made of multi-DOF energy harvesters to harness the benefits of velocity amplification by negating frictional effects on smaller, faster moving active masses.

The present disclosure provides a solution to avoid or substantially reduce such undesired frictions either in single DOF devices or in multiple DOF devices.

The apparatus as proposed by the present disclosure uses a self-righting magnetic guidance solution with negligible frictional losses.

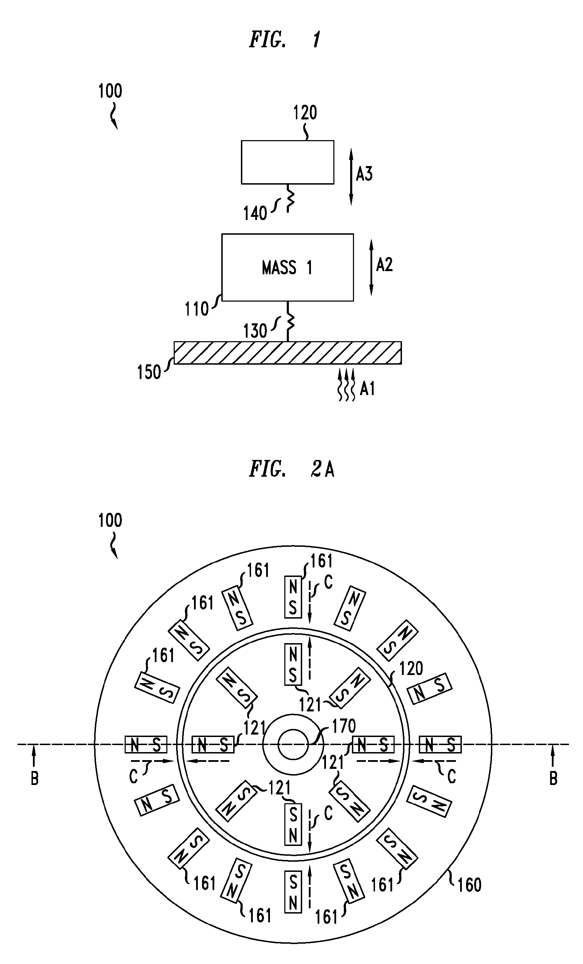

Figure 1 shows an example of a schematic structure illustrating some elements of an energy harvester in which some embodiments of the present disclosure may be implemented. For simplicity of illustration, other elements of the structure, such as for example a coil or other elements used for transducing energy are not shown. In the example of figure 1, the energy harvester is one operating under two degrees of freedom, however the disclosure is not so limited and it may likewise be applied to energy harvesters having one or more than two degrees of freedom.

The energy harvester 100 comprises a first mass element 110 and a second mass element 120. The first mass element 110 may be attached to an interior base 150 via a first spring 130. The base 150 may be part of the housing of the energy harvester (not completely shown in the figure) and may be fixed to a surface or object that may undergo mechanical disturbance (e.g. by vibration caused by other objects present in the environment) as symbolically shown by arrows A1. Contact between the first mass 110 and the second mass 120 is mediated using a second spring 140 as shown in the figure. It is to be noted that the first mass and the second mass are not necessarily attached and can be detached from one another.

In operation, when an external mechanical disturbance occurs in the environment surrounding the energy harvester 100, such mechanical disturbance is transferred to the base 150 as shown by arrows A1 causing the base to move. This movement is typically in the form of vibration or oscillation in the direction of arrow A1 and reverse. The movement of the base 150 is then transferred to the first mass 110 through the spring 130. Because of the resilient interaction between the first spring 130 and the first mass 100, the first mass 110 moves in the direction of the double-headed arrow A2 (up and down in the figure) which represents a line of vibration.

The movement of the first mass is then transferred to the second mass 120 via the second spring 140. Similar to the interaction between the first spring and the first mass, the second mass 120 moves in the direction of the double-headed arrow A3 (up and down in the figure) which represents a line of vibration. In normal operations, arrows A2 and A3 are parallel to each other. As mentioned above, the movements of the two masses give rise to two degrees of freedom.

In order to ensure that the masses 110 and 120 are not deviated during their movements from the desired displacement direction A2 and A3, known devices make use of guiding mechanisms. Examples of such guiding mechanisms are the use of bushings and bearings or a central axis which would pass through holes provided along the central axis of the masses; or the use of a plurality of lateral pairs of matching grooves and projections extending longitudinally (parallel to the central axis of the masses) along the sides of the housing. Such guiding mechanisms therefore make physical contact with the moving masses thereby causing friction which limits an optimal displacement amplitude of the masses.

According to the embodiments of the disclosure, permanent magnets are embedded in the energy harvester to align the masses during movement and/or resting.

The permanent magnets are suitably oriented so as to ensure a balance of forces between the mass and a surrounding structure, e.g. the housing. The mass can then move in a linear fashion along the desired line of vibration without having physical contact with the outer structure, hence decreasing frictional losses. The decrease in frictional losses therefore precludes the need for guiding mechanisms as described above, thus increasing robustness and allowing a higher power output as compared to existing technologies.

Herein, the term "line of vibration" is to be understood to refer to an imaginary line defining two opposite directions along which the mass element vibrates.

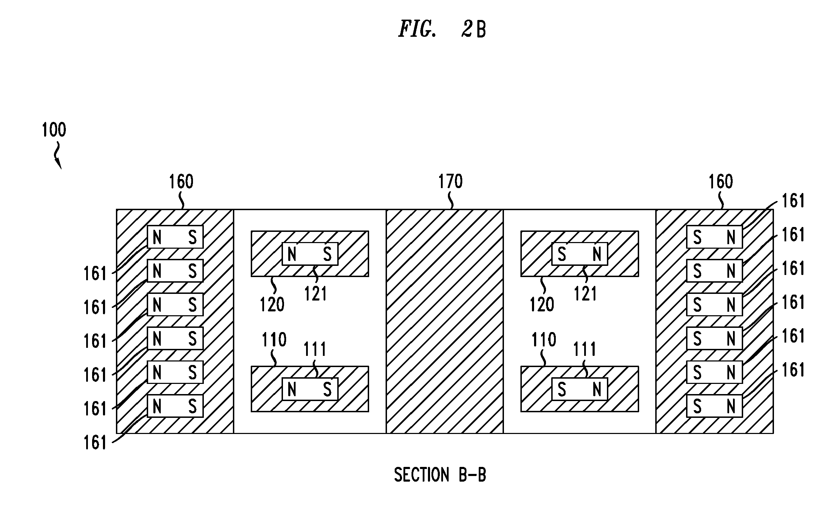

Figure 2A and 2B are exemplary schematic representations of an energy harvester 100 according to some embodiments. Figure 2A is a top view of the energy harvester 100 and figure 2B is a cross-sectional view of the same taken along the line B-B of figure 2A. In these figures, like elements have been provided with like reference numerals as those of figure 1.

Referring simultaneously to figures 2A and 2b, the energy harvester 100 comprises a first mass element (or simply mass) 110, a second mass element (mass) 120 and a housing 160 surrounding the masses 110 and 120. The masses 110 and 120 and the housing 160 may have any suitable shape as long as such shapes are in conformity with each other so as to allow the balancing of forces between each mass 110, 120 and the surrounding housing 160 as described above (and further detailed below). Preferably the masses 110, 120 and the housing 160 have shapes such that, once assembled, the assembly allows for a concentric positioning of each one of the masses with respect to the housing, as shown in the figures 2A and 2B. More preferably the masses 110 and 120 and the housing 160 each have circular cross-sections, as more clearly shown in figure 2A. However other cross-sectional shapes such as an equilateral polygon may also be used.

The first mass 110 is provided with a first set of permanent magnets 111. Optionally, the second mass 120 may also be provided with a second set of permanent magnets 121. This may be the case due to design considerations such as for example weight constraints.

In the example embodiment of figure 2A and 2B, both masses 110 and 120 are provided with respective permanent magnets 111 and 121. However the disclosure is not so limited and as stated above, the second mass may have no permanent magnets.

As shown more clearly in figure 2A the set of permanent magnets 121 of the second mass 120 are provided circumferentially proximate to the outer perimeter of the cross-section of the second mass 120. Preferably the permanent magnets 111, 121 in each respective mass are positioned such that the respective outward poles of the permanent magnets 121 are distributed equidistantly around the circumference of the mass, as more clearly shown in figure 2A. This contributes to a better equilibrium of forces around the mass. Preferably the outward poles of the permanent magnets are all of the same polarity. In the example of figures 2A and 2B the outward poles of the permanent magnets 111 and 121 show north polarities.

Similarly, the housing 160 is provided with a respective second set of permanent magnets 161. As shown more clearly in figure 2A, the second set of permanent magnets 161 is provided circumferentially proximate to the inner perimeter of the cross-section of the housing 160. Preferably the permanent magnets 161 in the second set are positioned such that the respective inward poles of the permanent magnets 161 are distributed equidistantly around the inner circumference of the housing, as more clearly shown in figure 2A. This, in conjunction with the similar arrangement of the first set of permanent magnets (in the masses), contributes to the better equilibrium of forces around the masses inside the housing. Preferably the inward poles of the second set of permanent magnets are all of the same polarity, the latter polarity being opposite to the polarity of the outward poles of the permanent magnets in the first set 111, 121. In the example of figures 2A and 2B the inward poles of the permanent magnets in the second set show south polarities.

The orientation of the opposing polarity of the permanent magnets in the first set with respect to the second set is important as the outer north polarities of the permanent magnets in the first set 111, 121, are attracted to the south polarities of the permanent magnets of the second set 161 in the housing. This force of attraction, represented by arrows C in figure 2A, is made equal between opposing poles around the circumference of the first and the second masses with respect to the housing, such that the magnetic forces of attraction collectively cancel each other, leading to a balance of forces which would maintain the first mass and the second mass in equilibrium. This would allow movement of the fist mass along the line of vibration without making physical contact with the housing, and without needing any guiding mechanism with physical contact.

In some embodiments, an opposite configuration may be used in which the inward poles of the second set of permanent magnets 161 are all of the same polarity, the latter polarity being the same as the polarity of the outward poles of the permanent magnets in the first set 111, 121.

In some embodiments, a combination of attractive and repulsive forces between the first set of the permanent magnets 111, 121 and the second set of permanent magnets 161 may be employed.

In any case however, a balance of forces (either attractive or repulsive) is ensured in order to maintain the masses at equilibrium when centrally positioned within the housing.

As can be more clearly seen in figure 2B, the orientation of the polarities of the permanent magnets 111 in the first mass and that of the permanent magnet 121 of the second mass are the same as one moves from the center of each mass to the outer perimeter thereof. In the example of figure 2A, the permanent magnets in each of the first and the second mass have south to north going from the center of the mass to the circumference thereof. Therefore the permanent magnets in the first mass and the permanent magnets of the second mass are positioned with the same polarity orientation with respect to each other (for example north-north on the circumference of the masses in Figure 2B). This arrangement leads to a repulsive force between the first mass 110 and the second mass 120 thus enhancing the movement of one mass in response to the movement of the other. This effect may improve power output.

The movement of the first mass 110, or the second mass 120 or both may be used to generate electric power by using a transducing mechanism.

For example, the first and second sets of permanent magnets 111 and 121 may further be used as sources for generating electric current in combination with a coil. In this regard, the energy harvester 100 may further comprise a coil 170 positioned relative the first and the second set of permanent magnets 111, 121 so as to act as a transducer to generate electric current by induction in response to the movements of the first and the second masses 110, 120. In the example of figures 2A and 2B, the coil is located along the central axis of the cylindrical housing 160. Other positions of the coil may also be envisaged, as long as the interaction of the coil with the permanent magnet to generate electric energy is ensured.

In this embodiment, therefore, the permanent magnets 111, 121 have a dual functionality being, on the one hand, ensuring a balanced positioning of the masses 110, 120 without physical contact to a guiding mechanism, and on the other, interacting with the coil 170 to generate electric energy through electromagnetic transduction.

Although not explicitly shown in figures 2A and 2B, the first mass 110 may be resiliently attached to the housing 150 by springs, in a similar fashion as springs 130 in figure 1. Likewise, the first mass and the second mass 120, as well as any additional masses that may be incorporated in the energy harvester 100 may be attached to each other by springs located between the masses (e.g. spring 140 in figure 1) to transfer mechanical energy on impact or movement of the masses. In order to avoid magnetic interaction between the springs and the magnets, springs made of non-magnetic material such as for example copper-beryllium material can be used.

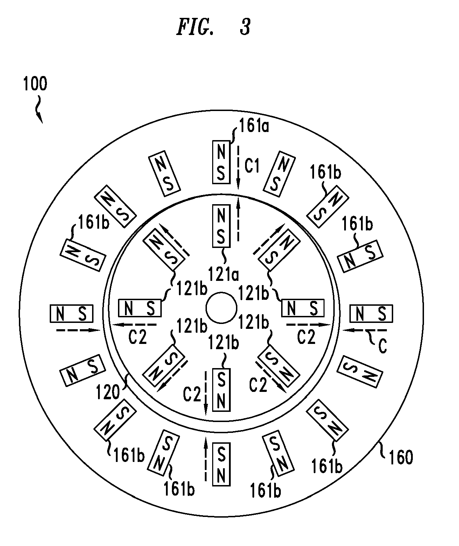

In case a mass is moved off-center, for example due an external physical impact on the housing, the interaction between the permanent magnets in the mass and the permanent magnets in the housing can force the mass to move back to an equilibrium position. This effect can be better understood with reference to figure 3.

Figure 3 is a schematic representation of the top view of the energy harvester 100 of figure 2A. Figure 3 is in many aspects similar to figure 2A and like elements therein are provided with like reference numeral as in figure 2A. The difference between figure 3 and figure 2A is that in figure 3, the second mass 120 is displaced off-center (moved toward the upper side in the figure). This causes the second mass 120 to be in an unbalanced position in which the permanent magnet 121 a in the second mass 120 and the permanent magnet 161 a of the housing attract each other to maintain the unbalanced situation, as represented by arrow C1. However, other permanent magnets in the second mass 120, generally shown by reference 121b, and other permanent magnets in the housing 161, generally shown by reference 161b, attract each other in the direction of arrows C2. As the number of the permanent magnets 116b attracting permanent magnets 121b toward a balanced position is higher than the ones attracting each other toward an unbalanced position, the sum of the magnetic forces represented by arrow C2 is greater than the force of the magnet force represented by arrow C1. This difference in forces causes the second mass 120 to be moved back to its balanced (equilibrium) position, as in figure 2A. This effect affords an advantageous self-correcting (or self-righting) property to the energy harvester 100 to ensure proper operation of the device.

In some embodiments, instead of using a coil as transducer for generating electric energy, use may be made of a piezoelectric energy generation. In this case piezoelectric materials (not shown in the figures) may be installed at a location between the first mass 110 and the second mass 120 such that the movement of a mass may be physically transferred to the piezoelectric material to cause stress in the latter and thereby generate electric power. In some embodiments, the electric energy may be harvested by a direct impact of a moving mass upon the piezoelectric material.

In such arrangements, piezoelectric elements may receive direct impact from the masses to thereby generate electricity. Alternatively, the piezoelectric elements may be positioned under the mechanical springs (130 or 140 in figure 1). Therefore, on impact, the spring compresses and transmits a compressive force on the piezoelectric element.

It is to be noted that although in the above structure physical contact occurs between the piezoelectric element and masses or springs, the frictional energy caused by such contact is negligible compared to the power generated by the impact on the piezoelectric element in the act of energy transduction.

In some embodiments, the energy harvester of the present disclosure may use other energy harvesting transduction techniques available to a person skilled in the related art such as for example a magnetostrictive effect or electrostatic effect.

For example a magnetostrictive effect may be present where strain is induced in a material due to changes in the magnetic field density surrounding the material. Moving a magnet near magnetostrictive material will generate strain in the material or alternatively straining the material causes a change in its magnetic field that can induce a current in a nearby coil. This type of material could therefore be included in the energy harvester of the present disclosure to react to the movement of the magnets or positioned such that it can be impacted directly by the moving masses (similar to the method described above for piezoelectric elements).

Alternatively a combination of piezoelectric and magnetostrictive elements, or other known energy transduction techniques known to a person skilled in the related art may be deployed.

In one specific arrangement, the movement of a magnetic mass relative to a magnetostrictive element may cause the element to react and deform. This deformation can be designed to interact and provide a force to a piezoelectric element, thus outputting electrical energy. In such designs, the magnetostrictive and/or piezoelectric elements may be positioned in the support structure (housing) of the energy harvester such that the motion of the masses relative to such elements actuates the transducer.

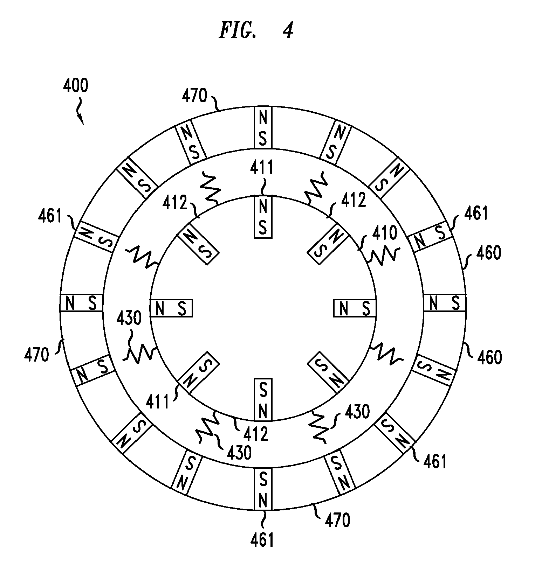

In some embodiments, instead of a movement of the masses along one line of vibration, such as the embodiments of figures 1 and 2, the energy harvester may be designed to operate with multiple axes of movement of the masses. An example of this embodiment is provided in figure 4.

Figure 4 shows a cross-sectional view of an energy harvester 400 comprising a mass element (or simply mass) 410 and a housing 460 surrounding the mass 410. The mass 410 and the housing 460 may have spherical shapes.

The mass 410 is provided with a first set of permanent magnets 411 provided circumferentially proximate to the outer surface 412 of the spherical mass 410. Preferably the permanent magnets 411 of the first set are positioned such that the respective outward poles of the permanent magnets 411 are distributed equidistantly around the outer surface 412 of the mass, as shown in figure 4. This contributes to a better equilibrium of forces around the mass. Preferably the outward poles of the permanent magnets are all of the same polarity. In the example of figure 4 the outward poles of the permanent magnets 411 show north polarities.

Similarly, the housing 460 is provided with a second set of permanent magnets 461. As shown in figure 4, the permanent magnets 461 of the second set are provided circumferentially proximate to the inner surface 462 of the spherical housing 460. Preferably the permanent magnets of the second set 461 are positioned such that the respective inward poles of the permanent magnets 461 are distributed equidistantly around the inner surface of the housing, as shown in figure 4. This, in conjunction with the similar arrangement of the first set of permanent magnets of the mass 410, contributes to the better equilibrium of forces around the mass inside the housing. In some embodiments the inward poles of the second set of permanent magnets 461 in the housing 460 are all of the same polarity, the latter polarity being opposite to the polarity of the outward poles of the first set of permanent magnets in the mass 410. In the example of figure 4 the inward poles of the permanent magnets in the housing show south polarities.

Similar to the previous embodiments of figures 2A, 2B, in the present case also the orientation of the opposing polarities of the permanent magnets 411 in the mass 410 with respect to the permanent magnets 461 in the housing 460, causes these permanent magnets to be attracted to each other. This attraction force is made equal between opposing poles around the outer surface 412 of mass 410 with respect to the inner surface 462 of the housing 460 such that the magnetic forces of attraction collectively cancel each other, leading to a balance of forces which would maintain the mass 410 in equilibrium. This would allow movement of the mass along the line of vibration without making physical contact with the housing, and without needing any guiding mechanism requiring physical contact.

Similar to the example of figures 2A and 2B, in this example also the polarities of the permanent magnets of the first set 411 and the corresponding polarities of the permanent magnets of the second set 461 may be arranged so as to ensure a balance of forces, either attractive (as shown in figure 4) or repulsive (not shown) between the magnets such that the mass 410 is maintained in equilibrium when positioned within the housing 460.

In some embodiments, a combination of attractive and repulsive forces between the first set of the permanent magnets 4111 and the second set of permanent magnets 461 may be employed such that the forces balance each other so as to maintain the mass in an equilibrium position.

A plurality of springs 430 may be attached to the outer surface 412 of the mass 410 to transfer movement from the housing to the mass and help move the mass toward a balanced position inside the housing 460. Here also, the springs may be chosen from non-magnetic material such as for example copper-beryllium. These springs may avoid an energy dissipating collision between the mass 410 and the housing 460.

In case an external force impacts the housing 460, the mass 410 may impact on the internal surface of the housing 460. In such case, the springs 430 would compress on contact with the housing and then expand causing the mass 410 to move inside the housing, which may lead to multiple impacts. However the interaction of the permanent magnets of the first set and the second set 411, 461 contributes to an eventual central positioning of the mass 410.

Furthermore, similar to the effect described with reference to figure 3, in this case also, a balance of forces toward bringing the mass 410 to its equilibrium position which is greater than the force tending to attract the mass 410 to the housing 460 will also act on the mass 410 to bring it to its equilibrium position. In this regard, the interaction between the first set of permanent magnets 411 in the mass 410 and the second set of permanent magnets 461 in the housing 460 may not by itself produce sufficient force to levitate the mass 410 and position it in equilibrium (this is mainly done by the action of the springs 430), however this interaction is capable of aiding the mass to arrive at such equilibrium position.

In some embodiments, depending on the strength of the permanent magnets used and the effective mass of the mass element 410, the mass element may likely rest on the springs at the lower part of the housing when at rest. But when impacted, the mass 410 will move and be attracted toward the centre of the housing 460. The springs will aid energy transfer on impact between the mass and the housing.

In some embodiments the springs may be attached to the mass 410 at one end and to the housing at an opposite end.

In order to transduce the movement of the mass 410 in electric energy, the housing may be provided with one or more coils 470. The coil(s) may be positioned relative the first set of permanent magnets 411 so as to act as a transducer to generate electric current by induction in response to the movement of the mass 410. In the example of figure 4, the coil 470 occupies the free spaces available between the permanent magnets 461 in the housing 460. Other positions of the coil may also be envisaged, as long as the interaction of the coil with the permanent magnet to generate electric energy is ensured.

Similar to the embodiments of figures 2A and 2B, in this embodiment also, the first set of permanent magnets 411 have a dual functionality being, on the one hand, ensuring a balanced positioning of the masses 410 without physical contact to a guiding mechanism, and on the other, interacting with the coil 470 to generate electric energy through electromagnetic transduction.

The embodiment of figure 4 may be suitable for use in situations where the mechanical disturbances from the external environment can be in multiple directions (X, Y or Z). The ability of the mass 410 to move in three directions leads to a more efficient and versatile harvesting of energy.

In some embodiments, instead of using a coil as transducer for generating electric energy in the energy harvester 400 of figure 4, use may be made of a piezoelectric energy generation. In this case piezoelectric materials (not shown in the figure) may be installed at a location relative to the mass 410 such that the movement of the mass 410 may be physically transferred to the piezoelectric material to cause stress in the latter and thereby generate electric energy. In some embodiments, the electric energy may be harvested by a direct impact of a moving mass upon the piezoelectric material similar to the embodiments discussed above with reference to a harvester moveable in one line of vibration. In some other embodiments, the energy harvester 400 of figure 4 may use other energy harvesting transduction techniques available to a person skilled in the related art such as for example a magnetostrictive effect or electrostatic effect. The principle of operation of such device is similar to the one already discussed above.

Alternatively a combination of piezoelectric and magnetostrictive elements, or other known energy transduction techniques known to a person skilled in the related art may be deployed.

Although the example embodiment presented in figure 4 illustrates the use of only one moving mass within one outer housing, the disclosure is not so limited and the principle of using permanent magnets in the moving mass and the surrounding mass may be extended to the use of multiple masses of decreasing size, with one mass nesting another of a smaller size therein, similar to a "Russian Doll' layout.

The various embodiments of the disclosure provide important advantages over the known solutions. One significant advantage is that the reduced friction between the moving parts improves the amplitude of their movements in response to a mechanical disturbance, thereby leading to the generation of increased output power, while at the same time it substantially extends lifetime of the energy harvester as compared to the known solution using mechanical guiding mechanisms.

Another important advantage is the robustness of the proposed energy harvester as the arrangement of the permanent magnets in the mass relative to the permanent magnets in the housing is such that in the event of any jolts or impacts capable of displacing the central mass from its equilibrium position, the mass can itself recover its equilibrium position.

The various embodiments of the present invention may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the invention.

## Claims

1. An apparatus comprising:
- a first mass element being bidirectionally moveable along a first line of vibration, said first mass element comprising a first plurality of permanent magnets;
- a housing surrounding at least partially the first mass element and comprising a second plurality of permanent magnets;
wherein the first plurality of permanent magnets and the second plurality of permanent magnets are configured to cooperate to thereby generate a plurality of magnetic forces, such that said magnetic forces collectively balance each other and allow movement of the first mass element along said first line of vibration.

2. The apparatus of claim 1, wherein a is spring attached to the first mass element and is configured to transfer a movement from the housing to the first mass element;

3. The apparatus of any one of the previous claims, wherein the first plurality of permanent magnets are provided circumferentially proximate to an outer perimeter of the cross-section of the first mass element.

4. The apparatus of claim 3, wherein the permanent magnets in the first plurality are positioned such that respective outward poles of said permanent magnets are distributed equidistantly around the circumference of the mass element.

5. The apparatus of any one of the previous claims, wherein the permanent magnets of the second plurality are provided circumferentially proximate to an inner perimeter of the cross-section of the housing.

6. The apparatus of any one of the previous claims, comprising a second mass element being bidirectionally moveable along said first line of vibration, said second mass element being at least partially surrounded by the housing and comprising a third plurality of permanent magnets; wherein the third plurality of permanent magnets and the second plurality of permanent magnets are configured to cooperate to thereby generate a plurality of magnetic forces, such that said magnetic forces collectively cancel each other and allow movement of the second mass element along said first line of vibration.

7. The apparatus of any one of the previous claims, further comprising a coil positioned relative the first set of permanent magnets to act as a transducer to generate electric energy by induction in response to movements of the first mass element and the second mass element.

8. The apparatus of any one of the previous claims configured to move a mass element in unbalanced position to a balanced position.

9. The apparatus of any one of the previous claims, further comprising a piezoelectric material positioned relative the first and the second mass elements to act as a transducer to generate electric energy in response to an impact of a mass element upon the piezoelectric material.

10. The apparatus of any one of the previous claims, further comprising a magnetostrictive material positioned relative the first and the second mass elements to act as a transducer to generate electric energy in response to a movement of a mass element relative to the magnetostrictive material.

11. The apparatus of claim 1, wherein one or more mass elements and the housing have respective spherical shapes.

12. The apparatus of claim 10, wherein the permanent magnets of the first plurality are provided circumferentially proximate to an outer surface of the spherical mass element and the permanent magnets of the second plurality are provided circumferentially proximate to an inner surface of the spherical housing.

13. The apparatus of claim 11, wherein the permanent magnets of the first plurality are positioned such that respective outward poles of the permanent magnets for the first plurality are distributed equidistantly around the outer surface of the mass element, and the permanent magnets of the second plurality are positioned such that respective inward poles of the permanent magnets for the second plurality are distributed equidistantly around the inner surface of the housing.

14. The apparatus of any one of the previous claims, wherein the spring is made of a non-magnetic material.

15. The apparatus of claim 10, further comprising a second mass element having a size smaller than the first mass element and being located inside the first mass element.
